# EUROPÄISCHE PATENTSCHRIFT

(11) **EP 0 471 982 B1**
(45) Veröffentlichungstag und Bekanntmachung des Hinweises auf die Patenterteilung: **04.05.1994**
(21) Anmeldenummer: 91111843.8
(22) Anmeldetag: 16.07.1991
(51) Int. Cl.: H05K 7/20

(54) **Einbausystem für elektrische Funktionseinheiten insbesondere für die Datentechnik**
Mounting system for electrical function units, especially for data technics
Système de montage pour unités électriques de fonction, notamment pour la technique de données

(30) Priorität: 03.08.1990 DE 4024737
(43) Veröffentlichungstag der Anmeldung: 26.02.1992
(73) Patentinhaber: Siemens Nixdorf Informationssysteme Aktiengesellschaft, 33102 Paderborn (DE)
(72) Erfinder: Wessely, Hermann, Dipl.-Ing., W-8000 München 60 (DE)
(74) Vertreter: Fuchs, Franz-Josef, Dr.-Ing.

(56) Entgegenhaltungen:
- EP-A- 0 113 794
- EP-A- 0 268 260
- EP-A- 0 428 859
- GB-A- 1 178 566
- US-A- 4 933 808

## Beschreibung

### Einbausystem für elektrische Funktionseinheiten insbesondere für die Datentechnik

Die Erfindung betrifft ein Einbausystem für elektrische Funktionseinheiten, insbesondere der Datentechnik, bestehend aus einer wechselnden Folge von mit Kühlkanälen für ein Kühlmittel und mit Durchkontaktierungen versehenen Kühlplatten und von in Mikroverdrahtungstechnik aufgebauten Leiterplatten, die an ihren beiden Oberflächen Kontaktflächen (Kontaktpads) zur Kontaktierung mit den Anschlußkontaktflächen (Anschlußpads) von integrierten Bauelementen aufweisen, die ihrerseits mit ihrer nicht mit Anschlußpads versehenen Seite an den Kühlplatten anliegen und bei dem den Funktionseinheiten die Betriebs- und Signalspannungen von außen über Stecker zugeführt sind.

In vielen Bereichen der Elektrotechnik, so beispielsweise in der Datentechnik werden, wegen der zunehmenden Zahl von Schaltfunktionen pro Raumeinheit, z.B. bei integrierten Schaltkreisen, auch immer höhere Anforderungen an den konstruktiven Teil von elektronischen Geräten gestellt. Die Zuführung zahlreicher Leitungen auf immer kleinerem Raum und die Ableitung der auftretenden Wärme sind dabei wesentliche zu berücksichtigende Faktoren.

Eine Bauweise, die dabei hohen Anforderungen im vorstehend genannten Sinne gerecht wird, ist bereits aus der europäischen Patentschrift 113 794 bekannt. Dort werden die mit Bauelementen, insbesondere chipsbestückten mehrlagigen Leiterplatten nebeneinander in einer Ebene in einem mit entsprechenden Ausnehmungen versehenen Gitterrahmen angeordnet, wobei jede dieser Leiterplatten eine eigene, aus gut wärmeableitendem Material bestehende Kühlplatte auf der bauteiletragenden Seite der Leiterplatte zugeordnet ist. Zusätzlich sorgt eine, sämtliche Einzelkühlplatten kontaktierende gemeinsame, mit Kühlmittel durchflossene weitere Leiterplatte für die Ableitung der den Einzelkühlplatten von den Leiterplatten zugeführten Wärme. Die Verbindung der Leiterplatten mit einer rückseitig an den Gitterrahmen angebrachten Verdrahtungsplatte wird über Andrucksteckverbinder hergestellt, die sich auf der Rückseite der Leiterplatten befinden. Diese planare Anordnung von Flachbaugruppen hat gegenüber den Vorgängersystemen, in denen auf einer Platterplatte mehrere Flachbaugruppen senkrecht zu dieser nebeneinander aufgesteckt wurden, zu einer erheblichen Verdichtung des Raum-Leistungsverhältnisses geführt, läßt jedoch eine weitere Steigerung nur noch in begrenztem Rahmen zu.

Um eine weitere Steigerung der Packungsdichte von hochintegrierten Bauteilen zu ermöglichen, wurde in der EP-A-0 428 859 bereits vorgeschlagen, in wechselnder Folge jeweils mehrere Flachbaugruppen und Kühlplatten flächenparallel hinter- bzw. aufeinander anzuordnen, so daß sie einen Quader bilden. Die Kühlplatten sind mit Kühlkanälen und mit dazu senkrechten Durchbrüchen versehen, in denen federnd ausgebildete Andruckkontakte für die Verdrahtung der Flachbaugruppen untereinander angeordnet sind. An den nicht mit Bauteilen bestückten Flächen der beiden äußeren Flachbaugruppen sind Steckerplatten mit Aussparungen zur Aufnahme von Leitungsstekkern für die Signalzuführung vorgesehen, wobei an den anderen beiden Seiten des Quaders Betriebsspannungen und an den dritten Seitenpaaren die Kühlmittelzuführung und die Kühlmittelbaführung für die Kühlplatten herangeführt werden. Dadurch wird eine dreidimensionale Verdrahtung innerhalb der Funktionseinheit und damit eine weitere Verdichtung von Bauelementen pro Volumeneinheit erreicht.

Aufgabe der vorliegenden Erfindung ist es, ein Einbausystem für elektrische Funktionseinheiten insbesondere für die Datentechnik zu schaffen, bei dem das Raum- Leistungsverhältnis weiter optimiert ist.

Zur Lösung dieser Aufgabe wird das Einbausystem derart ausgebildet, daß die Anschlußpads der integrierten Bauelemente mit den Kontaktpads der Leiterplatten über Kontaktmatten unmittelbar miteinander kontaktiert sind.

Dadurch wird eine höchste Bauelementedichte erreicht, da die integrierten Bauelemente (Chips) Kante an Kante angeordnet werden können. Auch die Qualität der Mikroverdrahtung der Leiterplatten, mit denen die integrierten Bauelemente kontaktiert sind, wird erhöht, da keine zusätzliche Wärmebelastung durch Anlöten der Bauelemente entsteht, da durch das Verwenden der Kontaktmatten dieses Anlöten der Bausteine überflüssig wird. Zugleich wird auch der Bauelementewechsel, da keine Lötarbeiten mehr erforderlich sind, erleichtert.

In weiterer Ausgestaltung kann die Erfindung derart ausgestaltet sein, daß zwischen den Kontaktpads der Leiterplatten Vertiefungen bis zurnächsten Metallebene der Leiterplatte vorgesehen sind, in denen diskrete Drähte für Änderungsverdrahtungen verlegbar sind, daß die diskreten Drähte mit auf dieser nächsten Metallebene freigeätzten Anschlußflecken verbindbar sind, die wiederum über Durchkontaktierungen mit den Kontaktpads an den Leiterplattenoberflächen verbunden sind.

Das bringt den Vorteil mit sich, daß kein zusätzlicher Raum für Diskretverdrahtung erforderlich ist, was ebenfalls die Anordenbarkeit der Chips Kante an Kante unterstützt.

Wenn man die nächste Metallebene auf Null-Volt-Potential legt, läßt sich bei der Änderungsverdrahtung ein definierter Wellenwiderstand herstellen.

Außerdem ist es vorteilhaft, daß die Anschlußpads für die integrierten Bauteile und die Anschlußstellen für die Durchkontaktierungen auf den Kühlplatten auf gleichem Niveau liegen. Dadurch kann für alle Anschlüsse eine durchgehende Kontaktmatte vewendet werden.

Befestigt man die integrierten Bauelemente fest auf den Kühlplatten, so läßt sich dadurch die Kühleffektivität weiter steigern, da kürzeste Wege von der Wärmequelle (Chip) zur Wärmesenke (Kühlplatte), die entweder als Kühlflüssigkeit Wasser oder flüssigen Stickstoff enthalten kann, hergestellt sind. Der Wärmeübergang vom integrierten Bauelement zur Kühlplatte ist wegen der unmittelbaren Montierung des Chips auf der Kühlplatte ebenfalls minimiert.

Bei lediglichem Andrücken der Bauelemente an die Kühlplatte durch die Kontaktmatte wird die rasche Auswechselbarkeit der Bauelemente erleichtert.

Anhand der Ausführungsbeispiele nach den FIG 1 bis 3 wird die Erfindung näher erläutert.

Es zeigen
- FIG 1: ein Explosivbild eines Teils einer Funktionseinheit,
- FIG 2: die Draufsicht auf die Kontaktseite der Mikroverdrahtung,
- FIG 3: den Schnitt III/III nach FIG 2.

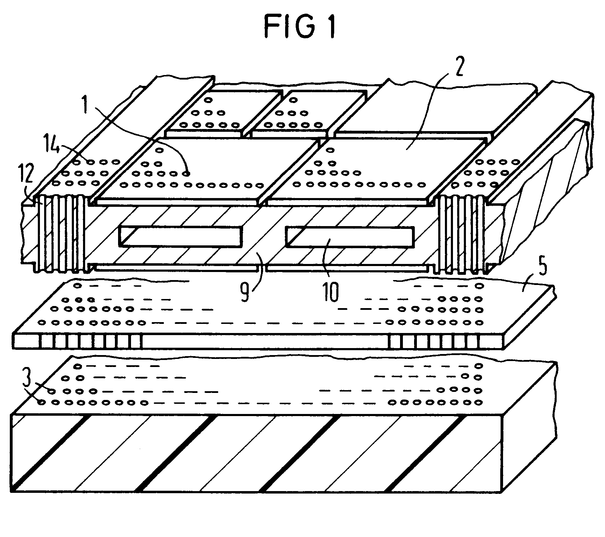

In FIG 1 ist ein Teilbereich einer Funktionseinheit gezeigt. Die integrierten Bauelemente 2 liegen unmittelbar mit ihrer kontaktabgewandten Seite der Kühlplatte 9 an, die mit Kühlkanälen 10 versehen ist. Diese Bausteine 2 können entweder fest (z.B. Klebung oder Lötung) mit der Kühlplatte 9 verbunden sein, zur Erreichung eines sehr guten Wärmeübergangs oder lediglich an diese angedrückt sein, wodurch die eventuell erforderliche Austauschbarkeit erleichtert wird. An den Seiten sind die Kühlplatten mit Durchkontaktierungen 12 versehen. Da sowohl die Kontakte für die Durchkontaktierungen als auch die Anschlußkontakte 1 der integrierten Bausteine 2 auf derselben Kontaktebene liegen, ist auf diese Weise eine einfache Kontaktierung der beidseitig auf der Kühlplatte 9 liegenden integrierten Bausteine 2 möglich. Die Kontaktierung der integrierten Bausteine 2 mit der in Mikroverdrahtung aufgebauten Leiterplatte 4 - im weiteren Mikroverdrahtung 4 genannt - mit der die Verdrahtung der integrierten Bausteine 2 auf jeweils einer Seite untereinander vorgenommen wird, erfolgt über die Kontaktmatte 5. Derartige Kontaktmatten sind bereits bekannt, sehe beispielsweise US-A- 4 933 808. Der sandwichartige Aufbau einer solchen Funktionseinheit läßt sich nun beliebig nach beiden Seiten fortsetzen, so daß auf der Oberseite des in FIG 1 dargestellten Teilstückes wieder eine Kontaktmatte 5 und anschließend eine Mikroverdrahtung 4 zu liegen kommt. Eine Kontaktmatte 5 stellt dann den Kontakt mit der nächsten Bauelementeebene über die Mikroverdrahtung 4 her, wobei die Bauelemente wiederum auf einer weiteren Kühlplatte angeordnet sind.

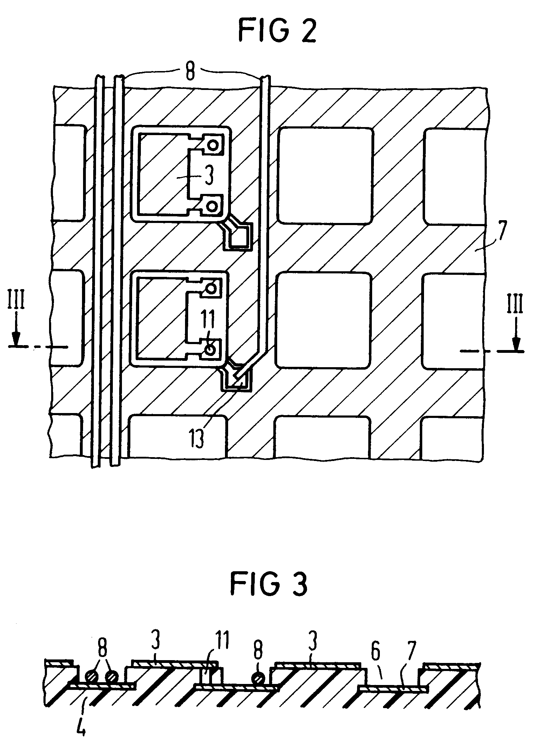

FIG 2 zeigt eine Draufsicht auf die Leiterplatte 4 in Mikroverdrahtung, deren Anschlüsse aus den Kontaktpads 3 bestehen, an die über die nicht dargestellte darüberliegende Kontaktmatte 5 die Anschlüsse an die Anschlußpads 1 der Bauelemente 2 geführt werden. Diese Kontaktpads 3 entstehen durch Freiätzung an der Oberfläche der Leiterplatten 4. Zwischen diesen Kontaktpads 3 sind dann Vertiefungen 6, z.B. mit Laser eingeätzt, die bis zur nächstliegenden Metallschicht 7 reichen. Diese Metallschicht 7 liegt auf Null-Volt Potential. Auf dieser Metallschicht 7 wird zwischen den Bauelementeanschlüssen die Direktverdrahtung 8 auf der Null-Voltebene, zur Erzielung eines kontrollierten Wellenwiderstandes verlegt. Auf dieser unteren Ebene wird die Änderungsverdrahtung an freigeätzte Kontaktflecken 13 kontaktiert. Die elektrische Verbindung dieser Kontaktflecken 13 zu den Bausteinanschlußpads 3 erfolgt über die parieellen Durchkontaktierungen 11.

Ein Querschnitt zeigt in FIG 3 die Kontaktpads 3 und die vorgesehenen Vertiefungen 6, in denen die Diskretverdrahtung verlaufen kann, sowie die Durchkontaktierungen 11 und die Null-Volt Metallfläche 7.

## Patentansprüche

1. Einbausystem für elektrische Funktionseinheiten, insbesondere der Datentechnik, bestehend aus einer wechselnden Folge von mit Kühlkanälen für ein Kühlmittel und mit Durchkontaktierungen versehenen Kühlplatten und von in Mikroverdrahtungstechnik aufgebauten Leiterplatten, die an ihren beiden Oberflächen Kontaktpads zur Kontaktierung mit den Anschlußpads von integrierten Bauelementen aufweisen, die ihrerseits mit ihrer nicht mit Anschlußpads versehenen Seite an den Kühlplatten anliegen und bei dem den Funktionseinheiten die Betriebs- und Signalspannungen von außen über Stecker zugeführt sind, **dadurch gekennzeichnet**, daß die Anschlußpads (1) der integrierten Bauelemente (2) mit den Kontaktpads der Leiterplatten (4) über Kontaktmatten (5) unmittelbar miteinander kontaktiert sind.

2. Einbausystem für elektrische Funktionseinheiten insbesondere für die Datentechnik nach Anspruch 1, **dadurch gekennzeichnet**, daß zwischen den Kontaktpads (3) der Leiterplatten (4) Vertiefungen (6) bis zur nächsten Metallebene (7) der Leiterplatten (4) vorgesehen sind, in denen diskrete Drähte (8) für Änderungsverdrahtungen verlegbar sind, daß die diskreten Drähte (8) mit auf dieser nächsten Metallebene (7) freigeätzten Anschlußflecken verbindbar sind, die wiederum über Durchkontaktierungen (11) mit den Kontaktpads (3) an den Leiterplattenoberflächen verbunden sind.

3. Einbausystem für elektrische Funktionseinheiten, insbesondere der Datentechnik nach einem der vorhergehenden Ansprüche, **dadurch gekennzeichnet**, daß die nächste Metallebene (7) auf Null-Volt Potential liegt.

4. Einbausystem für elektrische Funktionseinheiten, insbesondere der Datentechnik nach einem der vorhergehenden Ansprüche, **dadurch gekennzeichnet**, daß die Anschlußpads (3) für die integrierten Bauteile (1) und die Anschlußstellen (19) für die Durchkontaktierungen (12) auf den Kühlplatten (9) auf gleichem Niveau liegen.

5. Einbausystem für elektrische Funktionseinheiten, insbesondere der Datentechnik nach einem der vorhergehenden Ansprüche, **dadurch gekennzeichnet**, daß die integrierten Bauelemente (1) fest auf den Kühlplatten (9) befestigt sind.

6. Einbausystem für elektrische Funktionseinheiten, insbesondere der Datentechnik nach einem der Ansprüche 1 bis 4, **dadurch** **gekennzeichnet,** daß die integrierten Bauelemente (1) lediglich durch die Kontaktmatten (5) auf die Kühlplatten (9) gedrückt sind.

## Claims

1. Installation system for electrical functional units, preferably of data technology, comprising an alternating sequence of cold plates, which are provided with cooling ducts for a coolant and with through-plated holes, and of printed-circuit boards which are constructed using micro-wiring technology and have on their two surfaces contact pads to make contact with connecting pads of integrated components which, for their part, rest with their side which is not provided with connecting pads on the cold plates, and in the case of which installation system the operating and signal voltages are supplied to the functional units from the exterior via plugs, characterized in that the connecting pads (1) of the integrated components (2) and the contact pads of the printed-circuit boards (4) make direct contact with one another via contact mats (5).

2. Installation system for electrical functional units preferably for data technology, according to Claim 1, characterized in that depressions (6) as far as the next metal plane (7) of the printed-circuit boards (4) are provided between the contact pads (3) of the printed-circuit boards (4), in which depressions (6) discrete wires (8) can be laid for modification wiring, in that the discrete wires (8) can be connected to connecting spots which are etched free on this next metal plane (7) and in turn make contact with the contact pads (3) on the printed-circuit board surfaces via through-plated holes (11).

3. Installation system for electrical functional units, preferably of data technology, according to one of the preceding claims, characterized in that the next metal plane (7) is at a potential of zero volts.

4. Installation system for electrical functional units, preferably of data technology, according to one of the preceding claims, characterized in that the connecting pads (3) for the integrated components (1) and the connecting points (19) for the through-plated holes (12) are located at the same level on the cold plates (9).

5. Installation system for electrical functional units, preferably of data technology, according to one of the preceding claims, characterized in that the integrated components (1) are firmly mounted on the cold plates (9).

6. Installation system for electrical functional units, especially of data technology, according to one of Claims 1 to 4, characterized in that the integrated components (1) are merely pressed through the contact mats (5) onto the cold plates (9).

## Revendications

1. Système de montage pour des unités fonctionnelles électriques, notamment de la technique de transmission des données, constitué par une succession alternée de plaques de refroidissement équipées de canaux de refroidissement pour un fluide de refroidissement et de contacts traversants, et de plaquettes à circuits imprimés réalisées selon la technique du microcâblage et qui possèdent, sur leurs deux surfaces, des plots de contact pour l'établissement du contact avec les plots de connexion de composants intégrés, qui pour leur part s'appliquent, par leur face non équipée de plots de connexion, contre les plaques de refroidissement, et dans lequel les tensions de service et les tensions de signaux sont envoyées de l'extérieur par l'intermédiaire de connecteurs aux unités fonctionnelles, caractérisé par le fait que les plots de connexion (1) des composants intégrés (2) sont mis directement en contact avec les plots de contact des plaquettes à circuits imprimés (4) par l'intermédiaire de mats à contacts (5).

2. Système de montage pour des unités fonctionnelles électriques notamment pour la technique de transmission des données suivant la revendication 1, caractérisé par le fait qu'entre les plots de contact (3) des plaquettes à circuits imprimés (4) sont prévus des renfoncements (6), qui s'étendent jusqu'au plan métallique immédiatement suivant (7) des plaquettes à circuits imprimés (4) et dans lesquels des fils discrets (8) peuvent être posés pour des câblages de modification, que les fils discrets (8) peuvent être connectés aux plages de raccordement aménagées par corrosion dans ce plan métallique immédiatement suivant (7) et qui, à nouveau, sont reliées par l'intermédiaire de contacts traversants (11) aux plots de contact (3) situés sur les surfaces de la plaquette à circuits imprimés.

3. Système de montage pour des unités fonctionnelles électriques, notamment de la technique de transmission des données suivant l'une des revendications précédentes, caractérisé par le fait que le plan métallique immédiatement suivant (7) est placé au potentiel zéro volt.

4. Système de montage pour des unités fonctionnelles électriques, notamment de la technique de transmission des données, suivant l'une des revendications précédentes, caractérisé par le fait que les plots de connexion (3) pour les composants intégrés (1) et les plages de raccordement (19) pour les contacts traversants (12) sur les plaques de refroidissement (9) sont situés au même niveau.

5. Système de montage pour unités fonctionnelles électriques, notamment de la technique de transmission des données suivant l'une des revendications précédentes, caractérisé par le fait que les composants intégrés (1) sont fixés à demeure sur les plaques de refroidissement (9).

6. Système de montage pour unités fonctionnelles électriques, notamment de la technique de transmission des données suivant l'une des revendications précédentes, caractérisé par le fait que les composants intégrés (1) sont simplement repoussés par les mats à contact (5) sur les plaques de refroidissement (9).
